# EUROPÄISCHE PATENTSCHRIFT

(11) **EP 0 695 622 B1**
(45) Veröffentlichungstag und Bekanntmachung des Hinweises auf die Patenterteilung: **14.11.2001**
(21) Anmeldenummer: 95111614.4
(22) Anmeldetag: 24.07.1995
(51) Int. Cl.: B29C 59/14, D06M 10/00

(54) **Verfahren und Vorrichtung zur Plasmamodifizierung von flächigen porösen Gegenständen**
Method and apparatus for plasma modification of flat porous articles
Procédé et installation pour la modification par plasma d'objets poreux plats

(30) Priorität: 22.07.1994 DE 4426229; 15.09.1994 DE 4432919
(43) Veröffentlichungstag der Anmeldung: 07.02.1996
(73) Patentinhaber: Fraunhofer-Gesellschaft zur Förderung der angewandten Forschung e.V., 80636 München (DE)
(72) Erfinder: Oehr, Christian, D-72160 Horb-Ahldorf (DE); Schindler, Bernd, D-70178 Stuttgart (DE); Vohrer, Uwe, D-72076 Tübingen (DE); Müller, Michael, D-70599 Stuttgart (DE)

(56) Entgegenhaltungen:
- EP-A- 0 172 057
- EP-A- 0 192 510
- EP-A- 0 298 420
- EP-A- 0 559 609
- CH-A- 675 558
- DE-A- 3 248 730
- DE-A- 3 300 095
- DE-A- 3 922 601
- US-A- 4 457 145
- US-A- 4 550 578

## Beschreibung

Die vorliegende Erfindung betrifft die Modifizierung der Oberflächen von flächigen porösen Gegenständen wie Textilien, Membranen oder Papier und deren inneren Oberflächen mit Hilfe von in Niederdruckplasmen angeregten Reagenzien. Die Modifizierung geschieht durch Anbindung von chemischen Gruppen oder auch durch Abscheidung von Schichten mit anderen chemischen, physikalischen und morphologischen Eigenschaften als denen der Substrate.

Durch die wahlweise Anbindung von polaren und/oder unpolaren chemischen Gruppen lassen sich die Oberflächeneigenschaften in weiten Bereichen variieren, so beispielsweise die Oberflächenenergie von kleinen Werten (hydrophob) bis hin zu großen Werten (hydrophil).

In der Technik wurden derartige Modifizierungen bisher vor allem durch naßchemische Behandlungen erreicht. Meist ist die Wechselwirkung und Anbindung der eingesetzten Reagenzien physikalischer Art (Adsorption und Lösung) (Res. Discl. (1989) 305 S. 649-650), in einigen Fällen aber auch chemischer Natur (Ausbildung von Hauptvalenzen).

Naßchemische Behandlungen sind in der Regel sehr aufwendig und wurden durch die steigenden Anforderungen an die Umweltverträglichkeit immer teurer (EP 0,575,476 A1).

In jüngerer Zeit ist vorgeschlagen worden, Textilprodukte mit Hilfe von Niedertemperatur-Plasma zu behandeln (DE OS 33 00 095 A1). Unter den physikalischen Bedingungen eines Plasmas entstehen sowohl auf dem Substrat als auch im Prozeßgas Radikale, so daß eine chemische Bindung der Gasmoleküle am Substrat wie auch eine Vernetzung der Beschichtungsmoleküle möglich ist.

Das Plasmaverfahren hat im Prinzip den Vorteil, daß durch den geringen Chemikalienbedarf nur geringe Kosten für die Vorratshaltung und Entsorgung anfallen. Zudem bieten Plasmaverfahren besondere Vorteile hinsichtlich der Arbeitssicherheit und Umweltverträglichkeit, da verfahrensbedingt in geschlossenen Apparaturen gearbeitet werden muß. Außerdem lassen sich Oberflächenmodifizierungen erzielen, die auf naßchemischem Wege nur schwer oder gar nicht zu realisieren sind.

Die DE OS 33 00 095 zeigt eine Vorrichtung zur Durchführung eines solchen Verfahrens, in welcher das Substrat in gleichmäßigem Abstand zu zwei (durchbrochenen) Elektroden durch eine Behandlungskammer geführt wird. Eine Gasversorgungsdüse und eine Gasabsaugleitung sind so angeordnet, daß bei Anlegen einer Druckdifferenz das Gas auf seinem direkten Weg durch das zu behandelnde Substrat durchtreten müßte. Für die Durchführung des Verfahrens wird vorgeschlagen, im Behandlungsraum vor Einleiten des Prozeßgases den Druck auf vorzugsweise nicht mehr als 0,5 Torr abzusenken und sodann die Plasmabehandlung bei Drücken im Bereich von 0,1 bis 10 Torr durchzuführen, wobei als Behandlungsgas beispielhaft Luft und Sauerstoff genannt sind.

Mit dem genannten Verfahren können ausschließlich unspezifische Hydrophilierungsreaktionen durchgeführt werden, die den Anforderungen für Ausrüstungen in der Textilindustrie nicht gerecht werden. Darüberhinaus erhält man bei Einsatz der Vorrichtung unerwartet schlechte Ergebnisse in Bezug auf die Menge und Verteilung der aufgebrachten modifizierenden Teilchen.

In Melliand Textilberichte 6/1994, Seite 513 ff schlagen M. Rabe et. al. vor, Garne und Folien mit Hilfe von Plasmagasen stationär zu beschichten. Dabei liegt das Substrat auf einer Magnetleiste auf; die Zündung des Plasmas erfolgt im Bereich der von dieser Magnetleiste erzeugten Magnetfeldlinien. Verwendet wird dieses Verfahren unter Einsatz von hydrophobierenden Reagentien. Dieses Verfahren eignet sich besonders für glatte Substrate; innenliegende Oberflächen und insbesondere Zwickel in Geweben und dergleichen können jedoch nicht zuverlässig modifiziert werden. So reicht es für eine tiefreichende Hydrophob/Oleophob-Ausrüstung, die technischen Testverfahren genügen muß, nicht aus, das zu behandelnde flächige Substrat dem zuvor beschriebenen stationären Plasma auszusetzen. Zwar kann eine Erniedrigung der Oberflächenspannung und damit eine Hydrophobierung der Oberfläche erreicht werden (ein aufgelegert Wassertropfen perlt ab), aber bei strengeren Prüfverfahren, wie sie von der Textilindustrie gefordert werden (z.B. Bundesmann-Test = DIN-Vorschrift für Hydrophobierungstests) kommt es trotz dieser Ausrüstung zu einem schnellen Benetzen der Textilie.

In der DE 39 22 601 A1 werden ein Verfahren und eine Vorrichtung zur Niedertemperatur-Plasmabehandlung von textilen Substraten beschrieben. Auch Flächengebilde lassen sich so behandeln; sie werden in Form eines Haufwerks dem Plasmagas ausgesetzt, wobei das Haufwerk innere, mittlere und äußere Substratlagen bildet, die unterschiedlich weit von den Elektroden entfernt sind. Gemäß dieser Druckschrift werden keine Unterschiede zwischen diesen Lagen bezüglich der erzielten Behandlungseffekte gefunden; allerdings befinden sich alle Lagen in der konkret beschriebenen Ausgestaltung der Figuren in relativ großem Abstand zu beiden Elektroden.

Eine effektive Hydrophob- bzw Oleophobausrüstung, die technischen Anforderung genügt, bzw. eine spezifische Ausrüstung mit hydrophilen, nicht sauerstoffhaltigen funktionellen Gruppen wie z.B. Aminogruppen ist nach dem Stand der Technik nicht möglich.

Aufgabe der vorliegenden Erfindung ist es deshalb, ein Plasmaverfahren und eine für dieses Verfahren geeignete Vorrichtung zur Verfügung zu stellen, durch die die vorstehend genannten Nachteile beseitigt werden und mit deren Hilfe Flächengebilde auch komplizierter Geometrie gleichmäßig in zufriedenstellender Weise spezifisch modifiziert, beispielsweise hydrophobiert/oleophobiert werden können.

Die Aufgabe der vorliegenden Erfindung wird dadurch gelöst, daß vor der eigentlichen Behandlung ein Basisdruck bzw. Partialdruck der anfangs vorhandenen Gase deutlich kleiner als 0,1 mbar, nämlich ≤0,05 mbar, stärker bevorzugt µ 0,01 mbar und ganz besonders bevorzugt etwa 0.001 mbar in der Behandlungskammer eingestellt wird. Sodann wird/werden die Behandlungskammer (n) mit Trägergasen und/oder Monomergasen beschickt. Für Behandlungen, bei denen der Sauerstoffpartialdruck genau bekannt sein sollte, kann eine Prozeßsteuerung auch über einen Sauerstoffsensor erfolgen.

Weiterhin wird während der Plasmabehandlung eine Druckdifferenz zwischen der Ober- und der Unterseite des Gewebes derart aufrechterhalten, daß das Plasmagas gezwungen ist, durch den zu modifizierenden flächigen Gegenstand hindurchzuströmen. Das kann dadurch erreicht werden, daß eine Druckdifferenz über eine Absaugung hervorgerufen wird, die das Plasmagas durch die Textilie hindurchsaugt.

Überraschenderweise hat sich dabei gezeigt, daß die Minimierung des Restsauerstoffgehaltes in der Plasmaatmosphäre eine effektive Ausrüstung der zu behandelnden Substrate bewirkt.

Das vorliegende Verfahren eignet sich für jedes flächenförmige Substrat und jede poröse Bahnware wie textile Gebilde, Folien, Papierbahnen, Membranen und dergleichen, die aus beliebigem Material, beispielsweise Kunstfasern, Naturfasern oder Mischgeweben, bestehen können. Insbesondere eignet es sich für Substrate mit einer komplizierten Geometrie, beispielsweise gewebten, gewirkten, gelegten, geflochtenen textilen Gebilden, Matten sowie Membranen, Diaphragmen und dergleichen, bei denen erfindungsgemäß auch die inneren Oberflächen, z.B. Zwickel, modifiziert werden. Weiterhin lassen sich auch Sacklöcher durch geeignete Verfahrensvariationen, z.B. Druckwechsel, modifizieren.

Der flächige Gegenstand kann dabei falls erforderlich auch einer Vorbehandlung unterzogen werden, bevor er erfindungsgemäß modifiziert wird. Weiterhin kann eine nicht plasmagestützte Nachbehandlung zur Aufrechterhaltung, Verstärkung bzw. weiteren Optimierung der im Plasmaverfahren erhaltenenen Eigenschaften durchgeführt werden.

Als Prozeßgas wird ein Gas oder Gasgemisch eingesetzt, mit dem sich die Oberflächeneigenschaften des zu modifizierenden Flächengebildes in geeigneter Weise verändern lassen. So kann mit Kohlenwasserstoffen, Silanen oder Siloxanen, die auch teilweise oder vollständig fluoriert sein können, ein Hydrophobier-Effekt erzielt werden. Beispielhaft seien als einsetzbare Prozeßgase optional substituierte Alkylalkenylsilane und -siloxane wie Trimethylvinylsilan und teilweise oder vollständig fluorierte gesättigte oder ungesättigte Kohlenwasserstoffe, beispielsweise Hexafluorpropen oder Hexafluorbuten, angegeben. Insbesondere können auch Verbindungen, die eine tertiär-Butyl- oder teilweise bzw. vollständig fluorierte tertiär-Butyl-Gruppe enthalten, eingesetzt werden.

Weiterhin sind Verbindungen geeignet, die über eine funktionelle Gruppe zur Ankoppelung an das Substrat verfügen und eine länger teilfluorierte bzw. perfluorierte gesättigte oder teilweise ungesättigte Kohlenstoffkette besitzen.

Letztere führen zu einer oleophoben Ausrüstung. Hydrophile Eigenschaften können ebenfalls durch Einsatz geeigneter Prozeßgase wie z.B. Sauerstoff und sauerstoffhaltiger Reagenzien, aber auch Reagenzien, die z.B. stickstoffhaltige Gruppen, beispielsweise Aminogruppen enthalten, erzielt werden. Dabei kann infolge des anfangs erzielten Vakuums der Sauerstoffpartialdruck auch nach Spülen der Kammer mit Reagenz definiert eingestellt werden, so daß-reproduzierbare Ergebnisse erhalten werden.

Die vorgenannten Gase können auch in Mischung sowie Mischungen dieser Gase mit Inertgasen eingesetzt werden. Ebenso können die beschriebenen Effekte durch Absättigung der durch den Plasmaprozeß hervorgerufenen aktiven Stellen mittels Pfropfreaktion mit den obengenannten Reagenzien erreicht oder verstärkt werden. Auch eine geeignete Vorbehandlung, wie bereits weiter oben erwähnt, verstärkt den gewünschten Behandlungseffekt.

Die für die Aktivierung der Oberflächen und Reagenzien notwendige Energie wird mit Hilfe eines Niederdruckplasmas übertragen. Das Plasma wird durch elektrische oder elektromagnetische Anregung mit Gleich- oder Wechselspannung, vorzugsweise durch hochfrequente elektromagnetische Felder (z.B. mittels Hochfrequenzgeneratoren im MHz-Bereich oder Mikrowellenstrahlung im GHz-Bereich), erzeugt.

Die Montage bzw. Führung der flächigen, porösen Substrate in der Plasmakammer erfolgt so, daß diese direkt auf einer durchbrochenen Elektrode aufliegen. Wird nämlich das Substrat im Kathodenfall direkt auf der Elektrode geführt, ergeben sich die folgenden Vorteile: Das Substrat befindet sich in einem Bereich, in dem aus dem Plasma energiereiche Spezies auf das Substrat hin beschleunigt werden und damit die optimale Wirkung erreicht wird. Unerwarteterweise wird dabei auch die auf der Elektrode aufliegende Rückseite des Substrats in befriedigender Weise beschichtet. Zusätzlich hat sich herausgestellt, daß bei dieser Anordnung eine höhere Effektivität und auch gleichmäßigere Modifizierung von Vorder- und Rückseite sowie Zwickeln und dergleichen erzielt wird, was wahrscheinlich darauf zurückzuführen ist, daß das Gas auf seinem Weg durch die Plasmakammer gezwungen wird, durch das Gewebe hinduchzutreten, während bei der Anordnung der DE OS 33 00 095 A1 das zu behandelnde Substrat als Barriere wirkt, die von einem nicht zu vernachlässigenden Anteil des Gases umströmt wird, was zu einer "Verdünnung" des Plasmas führt und wahrscheinlich die beobachteten Mängel verursacht.

Im folgenden wird die erfindungsgemäße Vorrichtung unter Bezugnahme auf die Figuren beispielhaft näher erläutert.

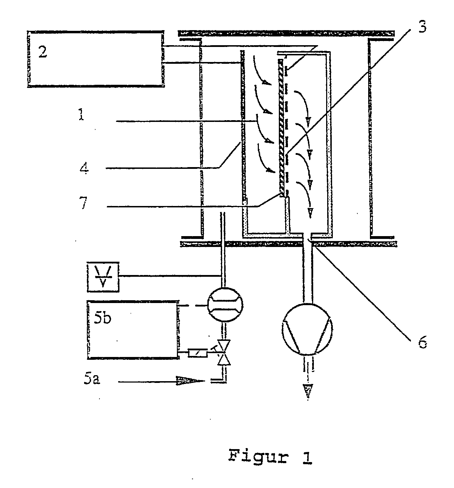

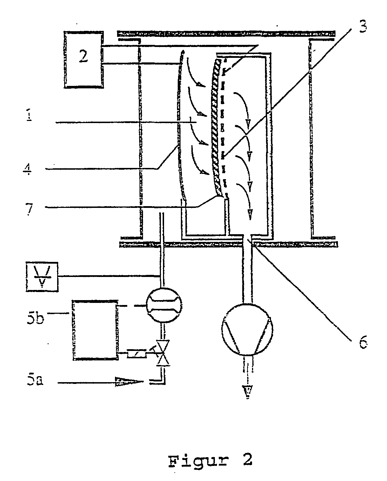

In der erfindungsgemäßen Vorrichtung wird, wie in Figur 1 (Schemazeichnung des Reaktors für die Plasmabehandlung von porösen Flachsubstraten) an einer beispielhaften Ausführungsform gezeigt, das Plasma in einer Reaktionskammer 1 z.B. mit einem Hochfrequenz-Generator 2 erzeugt, wobei die eine Elektrode 3 des Generators als durchbrochene oder perforierte oder auf andere Art mit Öffnungen versehene Flächenelektrode, beispielsweise als Siebelektrode, und die entsprechende Gegenelektrode 4 ebenfalls als Flächenelektrode ausgebildet ist, die in ihrer Geometrie an die Geometrie der durchbrochenen oder perforierten Flächenelektrode angepaßt ist. Die Kammer besitzt eine Zuführungseinrichtung für Prozeßgase 5a, hier mit einer Dosier- und Regeleinheit 5b sowie einen Auslaß für das Gas 6, die so zueinander angeordnet sind, daß das Gas auf seinem Weg vom Einlaß zum Auslaß den Raum zwischen den beiden Generator-Elektroden überstreicht. Wird zwischen Gaseinlaß und -auslaß eine Druckdifferenz aufrechterhalten, strömt das Gas durch das Substrat und die Öffnungen der durchbrochenen Flächenelektrode hindurch. Die Elektroden können einen Abstand von mehreren Zentimetern, beispielsweise ca. 4 cm, aufweisen. Der flächige Gegenstand (Substrat) 7 wird zur Beschichtung auf die durchbrochene Flächenelektrode aufgelegt. Vorzugsweise sind die Siebelektroden gekrümmt, um eine gleichmäßige Auflage zu gewährleisten. Dies ist in Figur 2 dargestellt, wobei der Aufbau der Vorrichtung der Figur 2 ansonsten dem in Figur 1 dargestellten enstpricht. Der flächige Gegenstand 7 ist hier ein Gewebe.

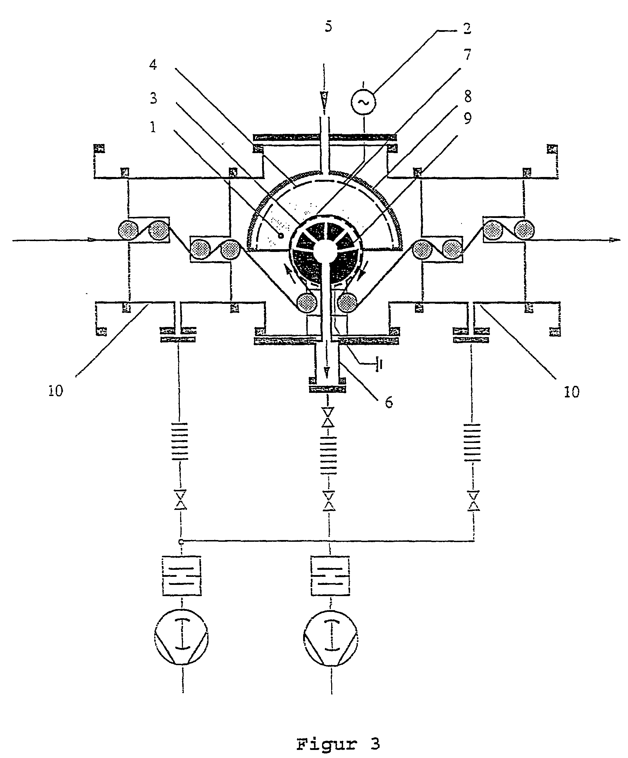

Wenn der flächige Gegenstand eine größere Längenausdehnung aufweist, es sich bei ihm beispielsweise um einen Stoffballen, um Garn oder lange Papier- oder Folienbahnen handelt, kann die Vorrichtung so ausgestaltet sein, daß eine kontinuierliche Behandlung möglich ist. Fig. 3 zeigt schematisch einen Reaktor für die kontinuierliche Plasmabehandlung von Flachsubstraten, z.B. Gewebebahnen. Das Bahnmaterial 7 kann durch die Reaktionskammer 1 geführt werden, in der das Plasma, z.B. mit einem Hochfrequenzgenerator 2, erzeugt wird. Die Flächenelektrode 3 weist hier die Form einer drehbaren Trommel auf, deren Mantel durchbrochen, perforiert oder in einer anderen geeigneten Weise mit Öffnungen versehen ist, so daß eine vollständige Durchdringung des Flächengebildes gewährleistet ist. Die Gegenelektrode 4 ist als ein konzentrisch zu dieser Trommel angeordnetes Segment eines Hohlzylinders ausgebildet. Der Abstand zwischen beiden Elektroden kann mehrere Zentimeter, beispielsweise 4cm, betragen. Die Prozeßgase werden über eine Zuführungseinrichtung 5 in die Prozeßkammer eingebracht und durch Öffnungen in der Gegenelektrode in den Elektrodenzwischenraum (Plasmaraum) geführt. Der Plasmaraum kann bis auf einen Spalt zur drehbaren Trommel hin mit einer Abschirmung 8 abgedichtet sein. Über einen feststehenden Absaugzylinder 9 kann das Plasma zum Auslaß 6 der Prozeßkammer geführt werden. Das bahnförmige Material kann von Luft zu Luft (durch Spalt-Vakuumschleusen) oder durch in Vakuumkammern befindliche Wickeleinrichtungen durch die Prozeßkammer geführt werden. In zusätzlichen Kammern 10 können weitere notwendige Bearbeitungsschritte wie z.B. Umspulen und/oder weitere Behandlungsschritte, wie z.B. Vorbehandlung durch Trocknung oder Nachbehandlung durch Propfreaktionen, durchgeführt werden. Bei Luft zu Luft Anlagen können sie weiterhin dazu dienen, eine stufenweise Evakuierung zu ermöglichen. Um den erforderlichen Basisdruck in der Behandlungskammer von Luft-zu Luft-Anlagen aufrechtzuerhalten, sind mehrere dieser Kammern notwendig.

Die Berücksichtigung einer geeigneten Vorbehandlung der flächigen, porösen Substrate in einer oder mehrerer der Plasmabehandlung vorgelagerten, ebenfalls vakuumgestützen Behandlungskammer(n) wie z.B. eine Trocknung, Aktivierung und/oder eine Entfernung den Prozess beeinträchtigender Adsorptionsschichten sowie eine Nachbehandlung durch z.B. Pfropfung und/oder Beschichtung mit nicht plasmagestützten Verfahren in an den Plasmaprozess nachgeschalteten evakuierten Behandlungskammern ist für eine hohen Ansprüchen genügende Ausrüstung von besonderem Vorteil und mit den bisher bekannten Anlagen nicht möglich.

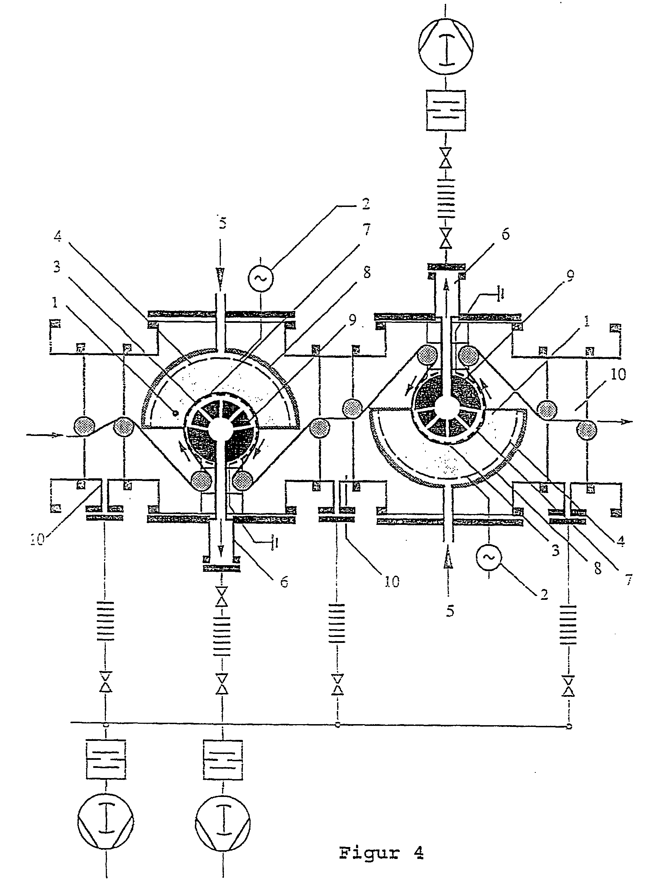

Es können auch mehrere Plasmabehandlungskammern hintereinander angeordnet werden. Hierdurch erzielt man eine schnelle Behandlung der Substrate. Die Behandlung erfolgt z.B. derart, daß ein oder mehrmals die Vorderseite und/oder ein oder mehrmals die Rückseite des zu behandelnden Materials dem Plasma zugewendet ist (Fig. 4, worin die Bezugszeichen die identische Bedeutung wie in Figur 3 besitzen).

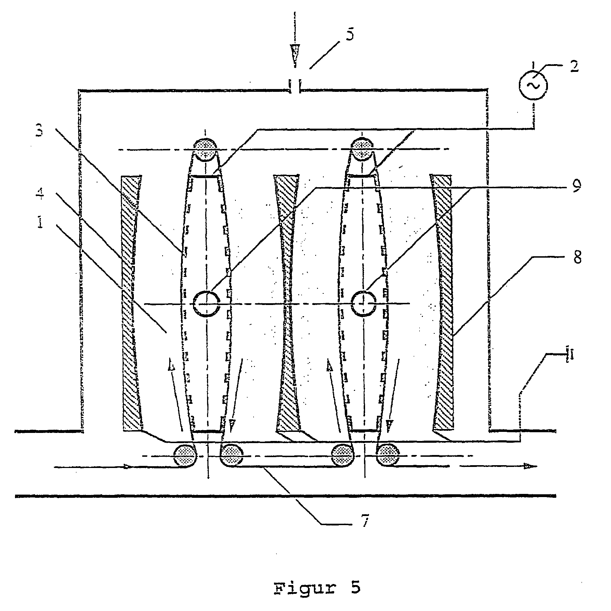

Eine weitere Ausführungsform stellt die Führung der Bahnware über konvex geformte, poröse Elektroden nach Figur 5 dar, wobei die Bahnware auch über eine größere Anzahl von Elektroden geführt werden kann. Die Führung der Bahnware kann dabei ebenfalls so erfolgen, daß ein oder mehrmals die Vorderseite und ein oder mehrmals die Rückseite des zu behandelnden Materials dem Plasma zugewendet ist. Dies ist einfach durch Umlenkrollen zu realisieren.

Das Prozeßgas kann weiterhin auch durch Öffnungen in den Gegenelektroden (4) in den Elektrodenzwischenraum eingelassen werden.

Das Plasma weist in der erfindungsgemäßen Vorrichtung üblicherweise einen Druck von 0,1 bis 5 mbar auf, wobei der Partialdruck der vor der Behandlung vorhandenen Umgebungsgase durch das erfindungsgemäße vorherige Abpumpen zu vernachlässigen ist. Der Gasfluß sollte im Bereich von 1 bis 1000 sccm liegen, und die Leistungsdichte kann bis etwa 250 mW/cm² betragen. Die Behandlungsdauer, in welcher das Plasma auf den flächigen Gegenstand einwirkt, beträgt etwa 1 sec bis 2 h. Bevorzugt liegt der Druck im Bereich von 0,2 bis 1,5 mbar, der Gasfluß im Bereich von 10 bis 100 sccm, die Leistung im Bereich von 10 bis 250 mW/cm² und die Behandlungsdauer im Bereich von 2 bis 10 min. Für sauerstoffempfindliche Prozesse, wie z.B. die Hydrophobierung, sind bei Luft zu Luft Behandlung Mehrkammeranlagen mit stufenweiser Evakuierung besonders bevorzugt. Der Basisdruck der Behandlungskammer sollte kleiner oder gleich 0,05 mbar sein. Die Kammer kann mit Trägergasen und/oder Monomergasen ein oder mehrmals gespült werden. Eine Vorbehandlung wie z.B. Trocknung verbessert ebenfalls die Ausrüstung.

Die Erfindung soll im folgenden anhand eines beispielhaft ausgewählten Gewebes aus Aramid näher erläutert werden. Aramidfasern sind hoch reißfest, sie halten in trockenem Zustand hohen mechanischen Belastungen stand. Allerdings geht diese Eigenschaft bei einem Aramid-Gewebe verloren, sobald es feucht wird, obwohl bekannt ist, daß die Fasern in nassem Zustand nicht mehr als 4 bis 5% ihrer Festigkeit verlieren (Z.A. Rogovin, "Chemiefasern", W. Albrecht, Hrsg., Georg Thieme Verlag, 1982, Seite 382). Wenn auch die Ursache dieser Eigenschaft noch nicht vollständig bekannt ist, wird angenommen, daß das in den Zwickelvolumina durch Kapillarkräfte gehaltene Wasser die Haftkräfte zwischen den Faserbündeln in den Garnen und den Berührpunkten der Garne in den Geweben herabsetzt und unter Belastung ein leichteres Auseinandergleiten der nassen als der trockenen Gewebefasern ermöglicht.

Mehrere Aramidgewebe wurden jeweils mit einem der folgenden Prozeßgase behandelt:
- Trimethylvinylsilan
- Hexafluorpropen
- Octafluorbuten

Die Verfahrensparameter waren:
- Basisdruck: 0,02 mbar
- Druck: 0,2 mbar angeben
- Gasfluß: 30 sccm
- Leistung: 100 m Watt/cm²
- Behandlungsfläche: 600 cm²
- Behandlungsdauer: 5 min.

Die erzielte Hydrophobierung wurde mittels der Bestimmung der Gewichtserhöhung der Gewebe sowie des Verlustes an Wasseraufnahmevermögen gemessen. Der Gewichtsanteil der Ausrüstung am Gewebe betrug zwischen 0,6 und 1,2%. Das Wasseraufnahmevermögen der ausgerüsteten Textilien nach Tauchen ging von 46,5 Gew.-% auf 15 Gew.-% zurück. Die modifizierten Gewebe eignen sich deshalb u.a. zur Verwendung in Gegenständen, die extremen mechanischen Belastungen ausgesetzt sind, beispielsweise Sportbekleidung für Fechter oder Schutzkleidung für gefährdete Personen.

Mit dem erfindungsgemäßen Verfahren bzw. der erfindungsgemäßen Vorrichtung lassen sich mit den oben genannten Verbindungen auch hydrophile Gewebe derart modifizieren, daß die erzielten hydrophoben Eigenschaften die gängigen Testverfahren bestehen. Die modifizierten Gewebe eignen sich deshalb zur Verwendung für Arbeits- bzw. Schutzkleidung.

## Patentansprüche

1. Verfahren zum Modifizieren von flächigen, porösen Gegenständen mit Hilfe eines Niederdruckplasmas, wobei die den flächigen, porösen Gegenstand enthaltende Plasmakammer vor der Zündung des Plasmas auf einen Basis-Innendruck der Anfangsgase von ≤ 0.05 mbar gebracht wird, sodann Reaktionsgas in die Kammer eingebracht wird und während der Behandlung eine Druckdifferenz zwischen der Ober- und der Unterseite des Gewebes aufrechterhalten wird, derart, daß das Plasma durch den flächigen Gegenstand hindurchströmt, **dadurch gekennzeichnet, daß** der flächige Gegenstand während der Plasmabehandlung auf einer durchbrochenen Flächenelektrode aufliegt.

2. Verfahren zum Modifizieren von flächigen Gegenständen mit Hilfe eines Niederdruckplasmas, **dadurch gekennzeichnet, daß** das eingesetzte Reaktionsgas Reagenzien enthält, die mit flächigen porösen Gegenständen auch an den inneren Oberflächen chemisch reagieren und/oder Polymerschichten bilden können.

3. Verfahren nach Anspruch 2, **dadurch gekennzeichnet, daß** die Reagenzien fakultativ teil- oder perfluorierte und/oder ungesättigte Gruppen enthaltende Kohlenwasserstoffe, Silane oder Siloxane sind oder umfassen.

4. Verfahren nach Anspruch 2, **dadurch gekennzeichnet,**
**daß** die Reagenzien eine ungesättigte Gruppe und mindestens eine Methyl-, Trifluormethyl,- tert.-Butyl- oder Perfluor-t-butylgruppe enthalten.

5. Verfahren nach einem der voranstehenden Ansprüche, **dadurch gekennzeichnet,**
**daß** das Plasma mit einem Druck von 0,1 bis 5 mbar, einem Gasfluß von 1 bis 1000 sccm und/oder einer Leistungsdichte von 10 mW/cm² - 250 mW/cm² zwischen 1 Sekunde und 2 Stunden lang auf den flächigen Gegenstand einwirkt.

6. Verfahren nach einem der Ansprüche 1l bis 5, **dadurch gekennzeichnet, daß** eine Vorbehandlung, insbesondere eine Trocknung oder Aktivierung, vorgeschaltet ist.

7. Verfahren nach einem der voranstehenden Ansprüche, **dadurch gekennzeichnet, daß** der flächige Gegenstand nach Plasmaaktivierung mit mindestens einem der in den Ansprüchen 2 bis 4 genannten Reagenzien gepfropft bzw. anders geeignet nachbehandelt wird.

8. Vorrichtung zum Behandeln von flächigen Gegenständen mit einem Niederdruckplasma, umfassend eine Reaktionskammer (1) mit einem Hochfrequenz-Generator (2) sowie mindestens eine erste Elektrode (3) des Generators, die als durchbrochene oder perforierte Flächenelektrode ausgebildet ist, und als Gegenelektrode eine zweite Elektrode (4), die ebenfalls als Flächenelektrode ausgebildet ist, wobei die zweite Elektrode in ihrer Geometrie an die Geometrie der durchbrochenen Flächenelektrode angepaßt ist, wobei die Kammer eine Zuführungseinrichtung (5) sowie einen Auslaß (6) für ein Prozeßgas aufweist, die so zueinander angeordnet sind, daß das Gas auf seinem Weg vom Einlaß zum Auslaß den Raum zwischen den beiden Flächenelektroden überstreicht, dort zu einem Plasma angeregt werden kann und durch die Öffnungen der durchbrochenen Flächenelektrode durchtritt, wenn eine Druckdifferenz zwischen Gaseinlaß und Gasauslaß aufrechterhalten wird, **dadurch gekennzeichnet, daß** Mittel zum Befestigen des flächigen Gegenstandes oder Umlenkrollen zwischen den beiden Elektroden vorgesehen sind, die den flächigen Gegenstand im direkten Kontakt zur ersten Elektrode halten oder führen.

9. Vorrichtung nach Anspruch 8, **dadurch gekennzeichnet, daß** die durchbrochene oder perforierte Elektrode (3) eine konvex geformte Elektrode ist.

10. Vorrichtung nach einem der Ansprüche 8 oder 9,
**dadurch gekennzeichnet, daß** die durchbrochene oder perforierte Flächenelektrode (3) die Gestalt einer drehbaren Trommel aufweist und die Gegenelektrode (4) die Gestalt eines bezüglich der Trommel-Elektrode konzentrischen Segmentes eines Hohlzylinders besitzt.

11. Vorrichtung nach einem der Ansprüche 8 bis 10,
**dadurch gekennzeichnet, daß** die Prozeßgase durch Öffnungen in der Gegenelektrode (4) in den Elektrodenzwischenraum geführt werden.

12. Vorrichtung nach einem der Ansprüche 8 bis 11,
**dadurch gekennzeichnet, daß** der Elektrodenzwischenraum bis auf zwei Spalte zum kontinuierlichen Ein- und Wegführen des flächigen Gegenstandes zur drehbaren Trommel hin mit einer Abschirmung abgedichtet ist.

13. Vorrichtung nach einem der Ansprüche 8 bis 12
**dadurch gekennzeichnet, daß** mehrere Plasmabehandlungskammern (1) hintereinander angeordnet sind.

14. Vorrichtung nach einem der Ansprüche 8 bis 13,
**dadurch gekennzeichnet, daß** Umlenkrollen vorgesehen sind, mit deren Hilfe die Bahnware so geführt werden kann, daß sie ein oder mehrmals mit der Vorder- und dann ein oder mehrmals von der Rückseite dem Plasma ausgesetzt wird.

15. Durch ein Plasmaverfahren modifizierter, flächiger Gegenstand **dadurch gekennzeichnet, daß** er ein Aramidgewebe ist oder enthält und sein Aufnahmevermögen für Wasser durch eine Beschichtung mit etwa 0.6 bis 1.2 Gew-% Auflage der durch das Plasma-Gas erzeugten Ablagerungen auf 30 % des ursprünglichen Wertes gesunken ist.

## Claims

1. Method for modifying flat porous objects with the aid of a low-pressure plasma, wherein the plasma chamber containing the flat porous object is brought before the ignition of the plasma to a base inner pressure of the initial gases of ≤ 0.05 mbar, then reaction gas is introduced into the chamber, and during the treatment a pressure difference between the upper and the lower sides of the fabric is maintained in such a way that the plasma flows through the flat object, **characterised in that** the flat object lies on an open-work flat electrode during the plasma treatment.

2. Method for modifying flat objects with the aid of a low-pressure plasma, **characterised in that** the reaction gas used contains reagents which can react chemically with flat porous objects even at the inner surfaces and/or form polymer coatings.

3. Method according to claim 2, **characterised in that** the reagents optionally are or include hydrocarbons, silanes or siloxanes containing partially fluorinated or perfluorinated and/or unsaturated groups.

4. Method according to claim 2,
**characterised in that**
the reagents contain one unsaturated group and at least one methyl-, trifluoromethyl, - tert - butyl or perfluoro-t-butyl group.

5. Method according to one of the preceding claims,
**characterised in that**
the plasma acts on the flat object for between 1 second and 2 hours at a pressure of 0.1 to 5 mbar, with a gas flow of 1 to 1000 sccm and/or a power density of 10 mW/cm² - 250 mW/cm².

6. Method according to one of claims 1 to 5,
**characterised in that** pre-treatment, in particular drying or activation, is inserted.

7. Method according to one of the preceding claims, **characterised in that** after plasma activation, the flat object is grafted with at least one of the reagents named in claims 2 to 4, or after-treated in some other suitable manner.

8. Apparatus for treating flat objects with a low-pressure plasma, comprising a reaction chamber (1) with a high-frequency generator (2) and at least one first electrode (3) of the generator, which is configured as an open-work or perforated flat electrode, and a second electrode (4) as the counter-electrode which is also configured as a flat electrode, the second electrode being matched in its geometry to the geometry of the open-work flat electrode, the chamber having a feed device (5) and an outlet (6) for a process gas, which are disposed in relation to one another in such a way that the gas on its way from the inlet to the outlet sweeps over the space between the two flat electrodes, can be excited there into a plasma and passes through the apertures of the open-work flat electrode when a pressure difference between gas inlet and gas outlet is maintained, **characterised in that** means are provided to secure the flat object or deflection rollers between the two electrodes, which hold or guide the flat object in direct contact with the first electrode.

9. Apparatus according to claim 8, **characterised in that** the open-work or perforated electrode is an electrode shaped convex.

10. Apparatus according to one of claims 8 or 9, **characterised in that** the open-work or perforated flat electrode (3) is in the shape of a rotary drum and the counter-electrode (4) is in the shape of a hollow cylinder segment concentric with the drum electrode.

11. Apparatus according to one of claims 8 to 10, **characterised in that** the process gases are guided through apertures in the counter-electrode (4) into the space between the electrodes.

12. Apparatus according to one of claims 8 to 11, **characterised in that** the space between the electrodes is sealed by means of a shield apart from two gaps for continuously guiding the flat object to and from the rotary drum.

13. Apparatus according to one of claims 8 to 12, **characterised in that** a plurality of plasma treatment chambers (1) are disposed the one behind the other.

14. Apparatus according to one of claims 8 to 13, **characterised in that** deflection rollers are provided, with the aid of which the web-type goods can be so guided that they are exposed to the plasma once or several times on the front side and then once or several times from the rear side.

15. Flat object modified by means of a plasma method, **characterised in that** that it is or contains an aramid fabric and its capacity for absorbing water is reduced to 30% of the original value by a coating with roughly 0.6 to 1.2 wt.-% thickness of the deposits generated by the plasma gas.

## Revendications

1. Procédé de modification d'objet poreux plat à l'aide d'un plasma basse pression, dans lequel on amène les chambres à flamme contenant l'objet poreux plat avant l'inflammation du plasma à une pression interne de base des gaz de départ ≤ 0,05 mbar, puis on introduit le gaz de réaction dans la chambre et au cours du traitement on maintient une différence de pression entre le côté supérieur et le côté inférieur du tissu, de manière que le plasma traverse l'objet plat,
**caractérisé en ce que**
l'objet plat au cours du traitement par plasma repose sur une électrode plate traversée de trous.

2. Procédé de modification d'objets plats à l'aide d'un plasma basse pression,
**caractérisé en ce que**
le gaz réactionnel utilisé contient des réactifs qui peuvent former avec des objets poreux plats même sur les surfaces internes des couches réagissant chimiquement et/ou des couches polymères.

3. Procédé selon la revendication 2,
**caractérisé en ce que**
les réactifs sont ou comprennent des hydrocarbures, silanes ou siloxanes facultativement partiellement fluorés ou perfluorés et/ou contenant des groupes insaturés.

4. Procédé selon la revendication 2,
**caractérisé en ce que**
les réactifs contiennent un groupe insaturé et au moins un groupe méthyle, trifluorométhyle, tert-butyle ou perfluoro-t-butyle.

5. Procédé selon l'une des revendications précédentes,
**caractérisé en ce que**
le plasma agit sur l'objet plat à une pression de 0,1 à 5 mbar, à un débit de gaz de 1 à 1000 cm³/seconde et/ou une densité de puissance de 10 mW/cm² à 250 mW/cm² pendant 1 seconde à 2 heures.

6. Procédé selon l'une des revendications 1 à 5,
**caractérisé en ce qu'**
un prétraitement, en particulier un séchage ou une activation, est effectué en amont.

7. Procédé selon l'une des revendications précédentes,
**caractérisé en ce que**
l'objet plat est greffé ou subit un autre post-traitement approprié après activation au plasma avec au moins l'un des réactifs mentionnés dans les revendications 2 à 4.

8. Dispositif de traitement d'objets plats avec un plasma basse pression, comprenant une chambre à réaction (1) avec un générateur haute fréquence (2) ainsi qu'au moins une première électrode (3) du générateur, qui est formée en électrode plate percée de trous ou perforée et comme contre-électrode une seconde électrode (4) qui est également formée en électrode plate, la seconde électrode étant adaptée dans sa géométrie à la géométrie de l'électrode plate percée de trous, la chambre présentant une direction d'introduction (5) ainsi qu'une sortie (6) pour un gaz de procédé, qui sont disposées l'une par rapport à l'autre de manière que le gaz sur son trajet de l'entrée à la sortie parcourt l'espace entre les deux électrodes plates, pour pouvoir y être excité en un plasma, et traverse les ouvertures de l'électrode plate percée de trous lorsqu'on maintient une différence de pression entre l'entrée de gaz et la sortie de gaz,
**caractérisé en ce que**
sont prévus des moyens pour la fixation de l'objet plat ou des rouleaux de renvoi entre les deux électrodes, qui maintiennent ou conduisent l'objet plat en contact direct avec la première électrode.

9. Dispositif selon la revendication 8,
**caractérisé en ce que**
l'électrode percée de trous ou perforée (3) est une électrode de forme convexe.

10. Dispositif selon l'une des revendications 8 ou 9,
**caractérisé en ce que**
l'électrode plate percée de trous ou perforée (3) présente la forme d'un tambour rotatif et la contre-électrode (4) possède la forme d'un segment de cylindre creux concentrique par rapport à l'électrode à tambour.

11. Dispositif selon l'une des revendications 8 à 10,
**caractérisé en ce que**
les gaz de procédé sont conduits dans l'espace compris entre les électrodes par des ouvertures dans la contre-électrode (4).

12. Dispositif selon l'une des revendications 8 à 11,
**caractérisé en ce que**
l'espace intermédiaire entre les électrodes est étanchéifié par une protection jusqu'à deux fentes pour l'introduction et l'extraction en continu de l'objet plat vers le tambour rotatif.

13. Dispositif selon l'une des revendications 8 à 12,
**caractérisé en ce que**
plusieurs chambres de traitement à plasma (1) sont disposées l'une derrière l'autre.

14. Dispositif selon l'une des revendications 8 à 13,
**caractérisé en ce que**
des rouleaux de renvoi sont prévus pour pouvoir conduire les matériaux en lés de manière à exposer une ou plusieurs fois au plasma leur face avant, puis une ou plusieurs fois leur face arrière.

15. Objet plat modifié par un procédé à plasma,
**caractérisé en ce qu'**
il est ou il contient un tissu d'aramide, et son pouvoir d'absorption de l'eau, grâce à un recouvrement avec d'environ 0,6 à 1,2 % en poids de dépôt produit par le gaz en plasma, est abaissé jusqu'à 30 % de sa valeur d'origine.
